# EUROPÄISCHE PATENTSCHRIFT

(11) **EP 0 480 335 B1**
(45) Veröffentlichungstag und Bekanntmachung des Hinweises auf die Patenterteilung: **17.09.1997**
(21) Anmeldenummer: 91116973.8
(22) Anmeldetag: 04.10.1991
(51) Int. Cl.: G03F 7/032, B41N 1/06

(54) **Lichthärtbares elastomeres Gemisch und daraus erhaltenes Aufzeichnungsmaterial für die Herstellung von Reliefdruckplatten**
Light curable elastomer composition and recording material obtained therefrom for the production of relief printing plates
Composition élastomère photodurcissable et matériau d'enregistrement obtenu de cela pour la production des plaques d'impression en relief

(30) Priorität: 11.10.1990 DE 4032238
(43) Veröffentlichungstag der Anmeldung: 15.04.1992
(73) Patentinhaber: Agfa-Gevaert AG, 51373 Leverkusen (DE)
(72) Erfinder: Gries, Willi-Kurt, Dr., Dipl-Chem., W-6200 Wiesbaden (DE)

(56) Entgegenhaltungen:
- EP-A- 0 224 164
- EP-A- 0 351 628
- EP-A- 0 399 329

## Beschreibung

Die Erfindung betrifft ein lichthärtbares, negativ arbeitendes Gemisch und ein daraus erhältliches Aufzeichnungsmaterial, das für die Herstellung von elastischen Reliefdruckplatten geeignet ist.

Lichthärtbare elastomere Gemische sind bekannt und enthalten gewöhnlich ein elastomeres Bindemittel, eine radikalisch polymerisierbare Verbindung und einen durch aktinische Strahlung aktivierbaren Polymerisationsinitiator. Druckplatten mit einer lichtempfindlichen Schicht aus einem derartigen Gemisch sind z. B. in der DE-A 22 15 090 (= GB-A 1 366 769) beschrieben. Sie lassen sich nach der Belichtung jedoch nur mit organischen Lösemitteln zum Reliefbild entwickeln.

In den Patentschriften DE-A 30 03 011 (= ZA 80/506), EP-A 0 130 828, DE-A 27 25 730 (= US-A 4 042 386) und DE-A 33 22 994 (= US-A 4 554 240) werden zwar wäßrig entwickelbare Aufzeichnungsmaterialien, die wasserlösliche Polymere, insbesondere teilweise oder vollständig verseifte Polyvinylacetate, als Bindemittel enthalten, offenbart. Jedoch ist die Wasserresistenz der daraus hergestellten Reliefdruckplatten gering, so daß ein Einsatz mit wasserverdünnbaren Druckfarben nicht möglich ist.

In den lichtempfindlichen Gemischen gemäß der DE-A 30 12 841 (= US-A 4 272 608) sind carboxylierte Butadien/Acrylnitril-Copolymerisate, in denen mindestens 25 % der Carboxygruppen mit einem Metallkation der Gruppen IIA oder IIB des Periodensystems neutralisiert sind, als Bindemittel enthalten.

Durch Umsetzung mit 3-Mercapto-propionsäure modifizierte und damit Carboxylgruppen enthaltende Butadien/Styrol-, Isopren/Styrol- und Butadien/Acrylnitril-Copolymerisate wie auch in gleicher Weise abgewandelte Polybutadiene und Polyisoprene sind in der US-A 4 446 220 als Bindemittel in lichtempfindlichen Zusammensetzungen offenbart.

Carboxylgruppen enthaltende gummielastische Copolymerisate, die durch Copolymerisation von 1,3-Butadien mit (Meth)acrylsäure, einer mehrfach ethylenisch ungesättigten Verbindung, wie Ethylenglykoldimethacrylat oder Divinylbenzol, und einer einfach ethylenisch ungesättigten Verbindung, wie Ethylacrylat, entstehen, sind in den EP-A 0 277 418 und 0 261 910 beschrieben. Die genannten Copolymerisate werden als Bindemittel in lichtempfindlichen Zusammensetzungen verwendet.

Eine lichtempfindliche elastomere Zusammensetzung für flexographische Druckplatten, die als Bindemittel ein hochmolekulares carboxyliertes Butadien/Acrylnitril-Copolymerisat enthält, ist in der US-A 4 517 279 genannt.

Die in der GB-A 2 179 360 offenbarte Zusammensetzung enthält neben dem carboxylierten Butadien/Acrylnitril-Copolymerisat noch ein chlorsulfoniertes Polyethylen und läßt sich gleichfalls mit einem wäßrigen Entwickler entwickeln.

Gemäß der EP-A 0 183 552 werden 1,3-Butadien/Methacrylsäure-, 1,3-Butadien/Methacrylsäure/Acrylnitril- oder Butadien/Methacrylsäure/Styrol-Copolymerisate als carboxylgruppenhaltige Bindemittel verwendet.

Die lichtempfindliche Zusammensetzung gemäß der EP-A 0 251 228 enthält ein gummielastisches Bindemittel mit einer Glastemperatur von weniger als -10 °C. Als Beispiele für ein solches Bindemittel sind auch carboxylgruppenhaltige Copolymerisate, wie 1,3-Butadien/(Meth)acrylsäure/Acrylsäureester-Copolymerisate, genannt. Die mit dieser Zusammensetzung hergestellten flexographischen Druckplatten sind in Wasser entwickelbar.

In der EP-A 0 273 393 werden chlorhaltige Polymere mit einer Glastemperatur von weniger als +5 °C als Bindemittel in lichtempfindlichen Zusammensetzungen für flexographische Druckplatten beschrieben.

Ist der Anteil der Carboxylgruppen in den polymeren Bindemitteln zu niedrig, so ist die flexographische Schicht mit wäßrigen Entwicklern nur schwer zu entwickeln. In diesen Fällen ist es erforderlich, der lichtempfindlichen Zusammensetzung polare Monomere bzw. Hilfsstoffe in einem hohen Anteil zuzusetzen, die ihrerseits einen hohen kalten Fluß des unbelichteten Materials zur Folge haben. Als "kalten Fluß" bezeichnet man das plastische Fließen über eine lange Zeitspanne infolge des Eigengewichts, innerer Materialspannungen oder äußerer Belastung. Eine Erhöhung des Carboxylgruppengehaltes ergibt zwar eine verbesserte wäßrige Entwickelbarkeit, jedoch verschlechtern sich gleichzeitig die gummielastischen Eigenschaften, und darüber hinaus reduziert sich die Resistenz gegenüber wasserhaltigen Druckfarben.

Aufgabe der Erfindung war es somit, lichtempfindliche, elastomere Gemische zu entwickeln, die lichtempfindliche Schichten ohne die bisherigen Nachteile für die Herstellung von Reliefdruckplatten ergeben. Nach der Belichtung bzw. Bestrahlung sollen diese Schichten unter milden Bedingungen wäßrig entwickelbar sein und daneben eine hohe Resistenz gegenüber mit Wasser verdünnbaren Druckfarben besitzen.

Diese Aufgabe konnte nun überraschenderweise durch die Verwendung von amphiphilen elastomeren Blockcopolymerisaten als Bindemittel gelöst werden. Als "amphiphile" Blockcopolymerisate werden hier solche Blockcopolymerisate bezeichnet, die sowohl wasseranziehende (hydrophile) als auch wasserabstoßende (hydrophobe) Abschnitte haben und daher Tensidcharakter besitzen.

Gegenstand der Erfindung ist somit ein lichthärtbares elastomeres Gemisch, das als wesentliche Bestandteile
a) ein amphiphiles elastomeres Bindemittel bzw. ein Gemisch solcher Bindemittel,
b) eine radikalisch polymerisierbare, mit dem Bindemittel verträgliche Verbindung mit mindestens einer endständig ethylenisch ungesättigten Gruppe und einem Siedepunkt bei Normaldruck oberhalb 100 °C und
c) eine Verbindung oder eine Kombination von Verbindungen, die unter Einwirkung von aktinischem Licht die Polymerisation der Verbindung (b) einzuleiten vermag,
enthält.

Der Grad der Oberflächenaktivität läßt sich in einfacher Weise durch passende Wahl des pH-Wertes einstellen: Bei einem hohen pH-Wert liegen die Carboxygruppen zu einem großen Anteil in deprotonierter Form vor, was eine höhere Polarität bewirkt und entsprechend eine stärkere Oberflächenaktivität.

Das erfindungsgemäße Gemisch ist dadurch gekennzeichnet, daß es als Bindemittel ein in wäßriger Lösung lösliches oder zumindest dispergierbares elastomeres Blockcopolymerisat der allgemeinen Struktur A-B, C-A-B, C-A-C-B, AₙXBₙ, (A-B)ₙX, CₙX(A-B)ₙ, (C-A)ₙXBₙ, (C-A-B)ₙX, CₙX(A-C-B)ₙ, (C-A)ₙX(C-B)ₙ, (C-A-C)ₙXBₙ und (C-A-C-B)ₙX enthält. Ferner sind symmetrische B-A-B- und B-C-A-C-B-Blockcopolymerisate und verzweigte Vertreter entsprechend X(B-A-B)ₙX, BₙXAₙXBₙ, X(B-C-A-C-B)ₙX, (B-C)ₙXAₙX(C-B)ₙ sowie BₙX(C-A-C)ₙXBₙ als Bindemittel verwendbar. In diesen Blockcopolymerisaten steht
- A: für hydrophobe weiche Blöcke mit einer Glastemperatur T_{g} von weniger als -30 °C,
- B: für hydrophile harte Blöcke, die saure Gruppen, vorzugsweise Carboxygruppen, enthalten und eine Glastemperatur T_{g} von mehr als +30 °C aufweisen,
- C: für hydrophobe harte Blöcke (T_{g} > +50 °C),
- X: für eine Einheit gebildet aus einer Verbindung mit zwei oder mehreren Vinyl- oder Isopropenylgruppen oder einen aus solchen Verbindungen entstandenen Homopolymerisat-Block, der in der Regel verzweigt bzw. vernetzt ist, und
- n: für das zahlenmäßige Verhältnis von A/B/C-Homopolymer-Blöcken zu der Einheit bzw. zu dem Homopolymerisat-Block X.

Als Monomere für die Blockpolymerisate A sind konjugierte Diene, wie 1,3-Butadien, Isopren, 2,3-Dimethyl-1,3-butadien, 1,3-Pentadien, 2-Methyl-3-ethyl-1,3-butadien, 3-Methyl-1,3-pentadien, 2-Methyl-3-ethyl-1,3-pentadien, 2-Ethyl-1,3-pentadien, 1,3-Hexadien, 2-Methyl-1,3-hexadien, 1,3-Heptadien, 1,3-Octadien, 3,4-Dimethyl-1,3-hexadien und 2-Phenyl-1,3-butadien geeignet. Der Einsatz von Gemischen geeigneter Diene bzw. die Anwendung anderer anionisch polymerisierbarer konjugierter Diene mit 4 bis 12 Kohlenstoffatomen kommen ebenfalls in Betracht. Bevorzugt sind Isopren und 1,3-Butadien.

Die Blockpolymerisate B resultieren bevorzugt aus α,β-ethylenisch ungesättigten Carbonsäuren wie Maleinsäure, Fumarsäure, Itaconsäure, Acrylsäure, Methacrylsäure und Crotonsäure. Andere Carbonsäuren mit in der Elektronendichte reduzierten Vinyleinheiten, wie z. B. Vinylbenzoesäure, können ebenfalls als Ausgangsmaterialien dienen.

Als Ausgangsmaterialien für Blockpolymerisate C sind Vinylaromaten, insbesondere Styrol, Alkylstyrol oder Vinylnaphthalin geeignet, wobei Styrol besonders bevorzugt ist.

Die Einheiten bzw. Blöcke X werden durch Reaktion der anionischen Kettenendglieder mit Verbindungen, die mindestens zwei Vinyl- oder Isopropenylgruppen enthalten, eingeführt. Vorteilhaft werden Di- und Trivinylbenzol sowie Verbindungen mit mindestens zwei Methacryloyloxy-Gruppen verwendet. Besonders bevorzugt sind 1,4-Divinylbenzol, 1,3-Diisopropenylbenzol, Ethylenglykoldimethacrylat und Trimethylolpropantrimethacrylat.

Detaillierte Angaben zu den Blockcopolymerisaten als solchen sowie Verfahren zu ihrer Herstellung sind in der gleichzeitig eingereichten deutschen Patentanmeldung P 40 32 237.8 zu finden.

Die durch Gelpermeationschromatographie (GPC) bestimmten Molekulargewichte bewegen sich zwischen 2.000 g/mol und 2.000.000 g/mol, vorzugsweise zwischen 15.000 g/mol und 200.000 g/mol. Die Massenanteile der beteiligten Blockkomponenten variieren von 20 bis 99 % für A, 1 bis 30 % für B sowie 0 bis 79 % für C.

Die erfindungsgemäßen lichtempfindlichen Gemische enthalten im allgemeinen 20 bis 95 Gew.-%, vorzugsweise 30 bis 90 Gew.-% des amphiphilen Bindemittels entweder ausschließlich oder in Verbindung mit anderen polymeren Materialien. Solche polymeren Materialien können chlorierte oder chlorsulfonierte Polyethylenverbindungen, statistisch aufgebaute oder segmentierte Dien-Polymere bzw. Copolymere sowie geeignete durch Polyaddition oder Polykondensation herstellbare thermoplastische Elastomere sein. Sie enthalten weiterhin mindestens eine radikalisch polymerisierbare olefinisch ungesättigte Verbindung sowie mindestens einen Photoinitiator.

Geeignete Monomere mit einer oder mehreren polymerisierbaren olefinischen Doppelbindungen sind insbesondere Ester und Amide der Acryl-, Methacryl-, Fumar- und Maleinsäure sowie Gemische dieser Verbindungen. Zusätzlich können die zur Ester- oder Amidbildung benötigten Alkohole bzw. Amine weitere Funktionalitäten, wie z. B. Ethereinheiten, Hydroxy-, prim., sek. oder tert. Aminogruppen enthalten. Beispiele für zur Esterbildung geeignete Alkohole sind offenkettige und cyclische Alkanole, wie Butanol, Hexanol, Octanol, Decanol, Dodecanol, Octadecanol, 2-Ethylhexanol, Cyclohexanol oder Borneol, aber auch Hydroxygruppen enthaltende Oligo- oder Polybutadiene und Hydroxygruppen enthaltende Oligo- oder Polyisoprene. Weitere geeignete Alkohole sind Alkandiole, polyfunktionelle Alkohole, und ähnliche Verbindungen, z. B. 1,4-Butandiol oder 1,6-Hexandiol, (Poly)ethylenglykol oder (Poly)propylenglykol, Glycerin, Trimethylolpropan, Butantriol, Pentaerythrit u. a. Die di- oder polyfunktionellen Alkohole können dabei teilweise oder vollständig verestert sein. Weitere Beispiele ungesättigter Verbindungen sind spezielle Ester und Amide der (Meth)acrylsäure, wie z. B. Dimethylaminoethyl(meth)acrylat, Dimethylaminopropyl(meth)acrylamid, 2-Butylaminoethyl(meth)acrylat, Ethylenbis(meth)acrylamid, Hexamethylenbis(meth)acrylamid, Diethylentriamintris(meth)acrylamid, Hydroxymethyl(meth)acrylamid und Bis-hydroxyethyl(meth)acrylamid. Die Menge an Monomeren liegt im allgemeinen bei etwa 5 bis 70 Gew.-%, bevorzugt bei etwa 10 bis 50 Gew.-% der nichtflüchtigen Bestandteile des Gemisches.

Als Photoinitiatoren für die erfindungsgemäßen Gemische kommen die bekannten Verbindungen in Frage, die eine hinreichende thermische Stabilität bei der Verarbeitung der Aufzeichnungsmaterialien sowie eine ausreichende Radikalbildung bei Belichtung zur Initiierung der Polymerisation der Monomeren aufweisen. Sie sollen Licht im Wellenlängenbereich von ca. 250 nm bis 500 nm unter Bildung von Radikalen absorbieren. Beispiele geeigneter Photoinitiatoren sind Acyloine und deren Derivate wie Benzoin, Benzoinalkylether, 1,2-Diketone und deren Derivate, z. B. Benzil, Benzilacetale wie Benzildimethylketal, Fluorenone, Thioxanthone, mehrkernige Chinone, Acridine und Chinoxaline, ferner Trichlormethyl-s-triazine, 2-Halogenmethyl-4-vinyl-[1,3,4]oxadiazol, mit Trichlormethylgruppen substituierte Halogenoxazole, Trihalogenmethylgruppen enthaltende Carbonylmethylenheterocyclen gemäß DE-A 33 33 450, Acylphosphinoxid-Verbindungen, wie sie z. B. in DE-A 31 33 419 beschrieben sind, und andere phosphorhaltige Photoinitiatoren, z. B. die in der DE-A 37 28 168 beschriebenen 6-Acyl-6H-dibenzo[c,e][1,2]oxaphosphorin-6-oxide, insbesondere das 6-(2,4,6-Trimethylbenzoyl)-6H-dibenzo[c,e][1,2]oxaphosphorin-6-oxid. Die Photoinitiatoren lassen sich auch in Kombination miteinander oder mit Coinitiatoren bzw. Aktivatoren verwenden, z. B. mit Michlers Keton und seinen Derivaten oder 2-Alkyl-anthrachinonen. Die Menge an Photoinitiator beträgt im allgemeinen etwa 0,01 bis 10 Gew.-%, bevorzugt etwa 0,5 bis 5 Gew.-% des Aufzeichnungsmaterials.

Oft ist es von Vorteil, dem Aufzeichnungsmaterial noch weitere Hilfs- und Zusatzstoffe zuzugeben, z. B. solche, die die thermische Polymerisation inhibieren, wie Hydrochinon und seine Derivate, 2,6-Di-tert.-butyl-p-kresol, Nitrophenole, Nitrosamine wie N-Nitrosodiphenylamin oder Salze des N-Nitrosocyclohexylhydroxylamins, z. B. dessen Alkali- oder Aluminiumsalze. Weitere übliche Zusätze sind Farbstoffe, Pigmente, Verarbeitungshilfsmittel und Weichmacher.

Die erfindungsgemäßen Gemische lassen sich für die Herstellung von Relief- und Flexodruckplatten durch Gießen aus Lösung oder Extrudieren und Kalandrieren zu Schichten einer Dicke von 0,02 bis 6 mm, vorzugsweise von 0,2 bis 3 mm, verarbeiten. Die Schicht kann auf die Oberfläche eines geeigneten Trägers laminiert oder eine Lösung der erfindungsgemäßen Gemische kann direkt auf einen Schichtträger aufgebracht werden.

Außer für die Herstellung von Reliefdruckplatten können die erfindungsgemäßen Gemische auch z. B. zur Herstellung von Flachdruckplatten, Tiefdruckzylindern, Siebdruckschablonen und Photoresists verwendet werden.

Geeignete Träger sind je nach Verwendungszweck z. B. Polyesterfolien, Stahl- oder Aluminiumbleche, Kupferzylinder, Siebdruckschablonenträger, Schaumstofflagen, gummielastische Träger oder Leiterplatten. Es kann auch vorteilhaft sein, auf die lichtempfindliche Aufzeichnungsschicht eine Deck- bzw. Schutzschicht, z. B. eine dünne Schicht aus Polyvinylalkohol oder Polyamid, oder eine abziehbare Deckfolie, z. B. aus Polyethylenterephthalat, aufzubringen. Weiterhin kann eine Vorbeschichtung des Trägers vorteilhaft sein. Die zusätzliche Schicht zwischen dem Träger und der lichtempfindlichen Schicht kann z. B. als Lichthofschutzschicht oder als Haftschicht wirksam sein.

Die erfindungsgemäßen Aufzeichnungsmaterialien können bildmäßig mit aktinischem Licht aus Lichtquellen wie Quecksilberdampflampen oder Leuchtstoffröhren belichtet werden, wobei die emittierte Wellenlänge bevorzugt zwischen 300 und 420 nm liegt. Das Entfernen der unbelichteten und unvernetzten Schichtanteile kann durch Sprühen, Waschen oder Bürsten mit Wasser oder basischen, wäßrigen Lösungen erfolgen. Als basische Materialien kommen beispielsweise Hydroxide, Carbonate oder Hydrogencarbonate der Alkalimetalle, Ammoniak und organische Amine in Betracht. Ferner können Netz- und Emulgiermittel sowie mit Wasser mischbare organische Lösemittel, wie z. B. aliphatische Alkohole, Ethylenglykole und Ethylenglykolmonoether, zugesetzt werden. Der Anteil der basischen Komponenten an der Lösung beträgt im allgemeinen 0,01 bis 5 Gew.-% bevorzugt 0,1 bis 1 Gew.-%. Der Anteil an organischem Lösemittel ist dabei kleiner als 40 Gew.-%, bevorzugt kleiner als 20 Gew.-%.

Alternativ können auch organische Lösemittel, wie aromatische Kohlenwasserstoffe, Chloralkane und Ketone als Entwickler verwendet werden. Beispiele dafür sind Toluol, Xylol, 1,1,1-Trichlorethan, Tetrachlorethylen, Methylisobutylketon u. a., die dabei auch in Kombination mit niederen Alkoholen, z. B. n-Butanol, eingesetzt werden können. Zweckmäßig werden die entwickelten Reliefformen bei Temperaturen bis 120 °C getrocknet und gegebenenfalls photochemisch oder chemisch nachbehandelt.

Die erfindungsgemäßen Aufzeichnungsmaterialien eignen sich besonders zur Herstellung von Druckformen, vor allem Hoch- oder Reliefdruckformen, die besonders für den Flexodruck geeignet sind.

Die Erfindung wird durch die nachstehenden Beispiele erläutert. Wenn nichts anderes angegeben, stehen %-Angaben für Gew.-%-Angaben.

### Herstellungsbeispiel:

In einem trockenen Glasautoklaven bzw. einer Glasapparatur werden unter Inertgasatmosphäre zu einer Mischung aus 40 ml Toluol und 80,6 mmol Styrol 1,33 ml 1,6 M n-BuLi-Lösung in Hexan gegeben. Das sich erwärmende Reaktionsgemisch wird 2 h im Wasserbad gerührt, mit 160 ml Toluol verdünnt und nach Zugabe von 500 mmol Isopren noch 2,5 h weitergerührt. Die dickflüssige Reaktionslösung wird mit 3,80 mmol 1,1-Diphenylethen und 200 ml THF versetzt. Anschließend wird mit einer NaCl/Eiswasser-Mischung abgekühlt. Nach Zugabe von 99,6 mmol t-Butylmethacrylat wird noch 1 h im Kältebad gerührt und die Polymerisation mit 1 ml Methanol abgebrochen. Die Reaktionslösung wird anschließend in das 10-fache Volumen Methanol feinverteilt eingetragen. Das ausgefallene Polymere wird abgesaugt, gewaschen und getrocknet. Zur Entfernung der t-Butyl-Schutzgruppe wird das isolierte Material in Toluol gelöst, mit 5 Gew.-% p-Toluolsulfonsäure, bezogen auf t-Butylmethacrylat, versetzt und 6 h auf 80 °C erwärmt. Nach Abkühlen wird mit MeOH ausgefällt, gewaschen und im Vakuum bei Raumtemperatur getrocknet.

Ausb.: 97 % (83 %); Mₚ (GPC): 49000 (vor Abspaltung der tert.-Butyl-Schutzgruppe); SZ: 68,0 mg KOH/g

### Beispiel 1:

| | |
|---|---|
| 37,0 g | eines gemäß Herstellungsbeispiel synthetisierten S-I-MAA-Blockcopolymeren mit 19 % Styrol, 71 % Isopren und 10 % Methacrylsäure, |
| 37,0 g | eines S-I-S-Blockcopolymeren (^{(R)}Europren Sol T 190), |
| 16,0 g | flüssiges Polyisopren (^{(R)}Kuraray LIR 403), |
| 8,5 g | Trimethylolpropantriacrylat, |
| 1,0 g | Benzildimethylketal und |
| 0,5 g | 2,6-Di-tert.-butyl-4-methyl-phenol |

werden in 300 g Toluol gelöst und anschließend in einen Trocknungsrahmen gegossen. Die nach dem Abdampfen des Lösemittels erhaltene lichtempfindliche Schicht wird in einer Plattenpresse zwischen zwei 0,125 mm dicken, mit Haft- bzw. Anti-Tack-Schicht versehenen Polyesterfolien auf 3,0 mm Schichtdicke gepreßt. Nach 20 s Rückseitenbelichtung wird 8 min in einem UVA-Flachbelichter bildmäßig belichtet und anschließend mit einem Entwickler, bestehend aus 15 Teilen Diethylenglykolmonobutylether und 85 Teilen einer 1%igen wäßrigen Natronlauge, bei 60 °C 20 min behandelt. Die belichtete Platte weist eine Shore-A-Härte von 30 auf und ergibt in Wasser, in Ethanol bzw. in einem Gemisch aus 85 Teilen Ethanol und 15 Teilen Ethylacetat einen Quellungswert von 0,3 %, 1,4 % bzw. 5,2 %.

### Beispiele 2 bis 9:

Analog zum Beispiel 1 werden weitere Photopolymer-Druckplatten mit den in Tabelle 1 beschriebenen Zusammensetzungen hergestellt und nach Belichtung entsprechend Beispiel 1 entwickelt. Die dazugehörigen Werte für Härte und Quellung sind in Tabelle 2 zusammengestellt.

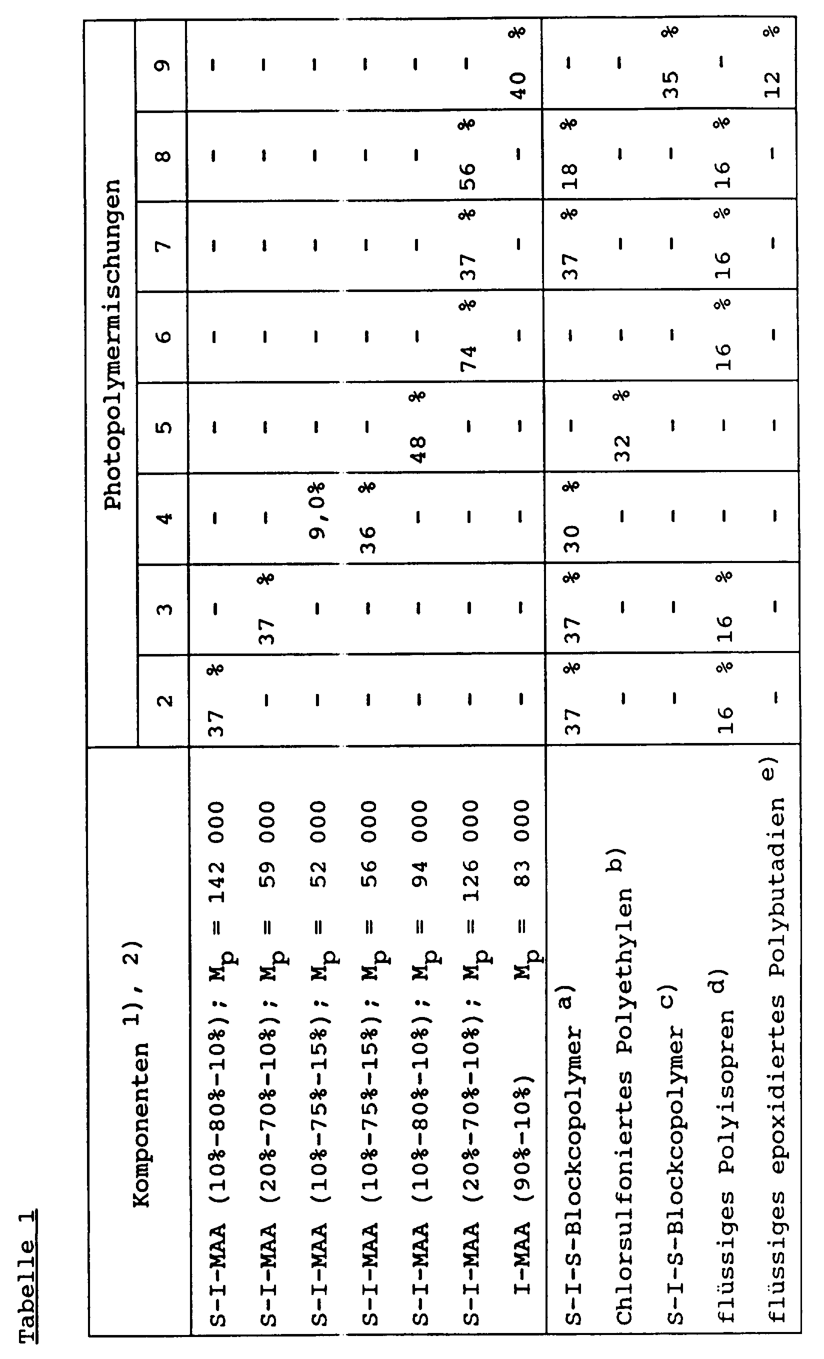

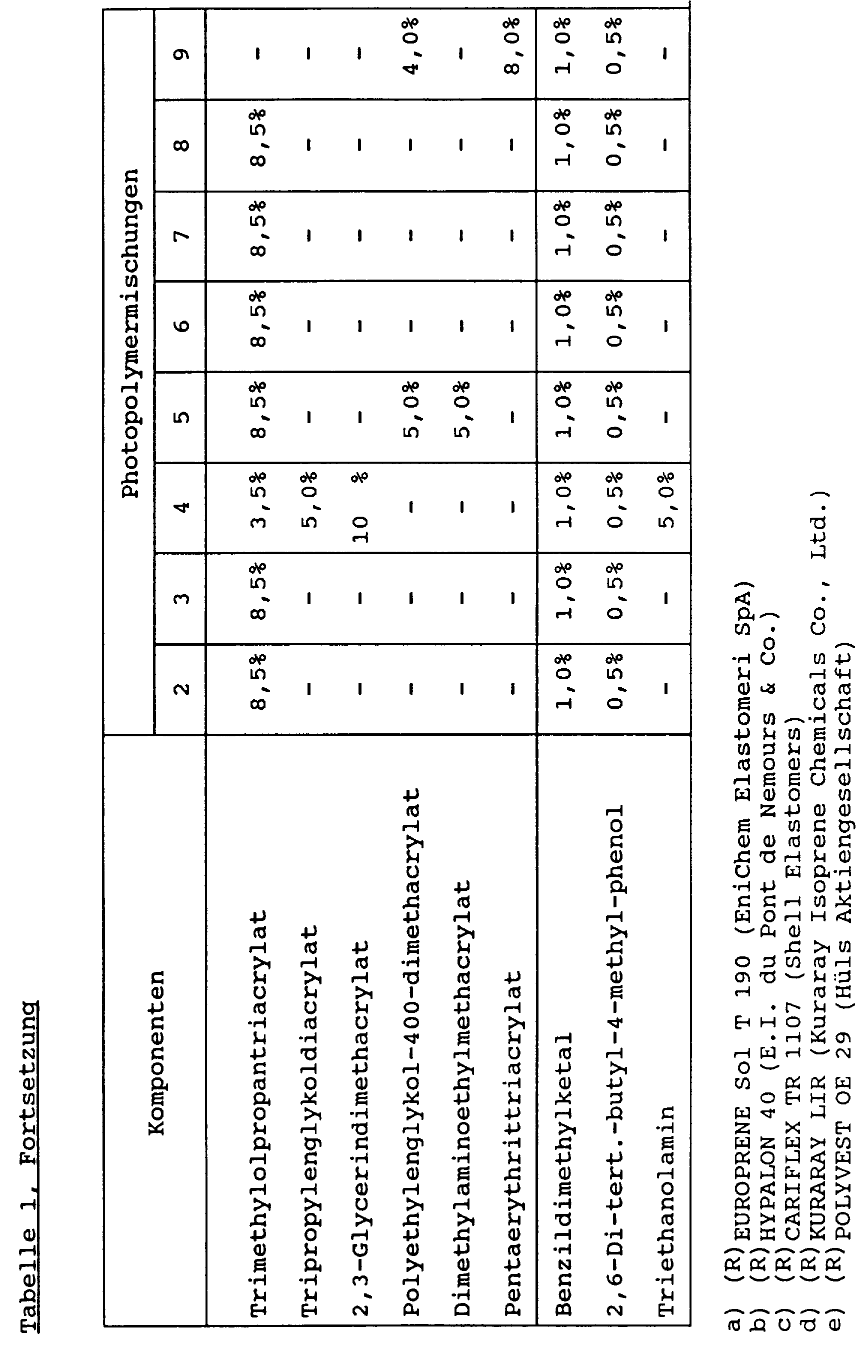

**Tabelle 2**

| **Quellungs-* und Härtewerte der Photopolymermischungen** | | | | |
|---|---|---|---|---|
| Beispiel Nr. | H₂O | EtOH | EtOH/EtOAc (85/15) | Härte nach 30 s |
| 2 | 0,25 % | 1,7 % | 5,9 % | 43 Shore-A |
| 3 | 0,20 % | 0,46 % | 5,6 % | 43 Shore-A |
| 4 | 0,65 % | 0,67 % | 4,7 % | 43 Shore-A |
| 5 | 0,88 % | 0,79 % | 3,8 % | 38 Shore-A |
| 6 | 3,9 % | 17 % | 30 % | 56 Shore-A |
| 7 | 1,1 % | 2,9 % | 7,9 % | 53 Shore-A |
| 8 | 0,80 % | 2,5 % | 7,2 % | 31 Shore-A |
| 9 | 2,8 % | 3,9 % | 9,5 % | 25 Shore-A |

| | | | | |
|---|---|---|---|---|
| *** Berechnung nach Quellung = (m**_{**24h**}**-m**_{**0**}**)/m**_{**0**} **· 100** **Tabellenanhang:** 1) I = Isopren, MAA = Methacrylsäure, S = Styrol 2) Mₚ = mittleres Molekulargewicht (Peakmaximum der GPC-Kurve) ermittelt durch GPC-Messung mit THF als Lösemittel und Polyisopren als Standard (Material vor Abspaltung der Schutzgruppen) | | | | |

### Beispiel 10:

Eine Mischung bestehend aus

| | |
|---|---|
| 80,0 g | eines S-I-S-Blockcopolymeren (^{(R)}Europren Sol T 190) |
| 80,0 g | eines (S-I)ₙX(MAA)ₙ-Blockcopolymeren (S = 9,2 %, I = 79 %, MAA = 9,8 %, X = Divinylbenzol = 2,1 %, Mₚ = 225000), |
| 17,0 g | Trimethylolpropantriacrylat, |
| 20,0 g | Nonaethylenglykoldimethacrylat, |
| 2,0 g | Benzildimethylketal und |
| 1,0 g | 2,6-Di-tert.-butyl-Hydroxytoluol |

wird auf einem Zweiwalzenstuhl bei 150 °C so lange geknetet bis eine homogene, klare Masse entsteht. Diese lichtempfindliche Masse wird dann in einer Plattenpresse bei 120 °C zwischen zwei 0,125 mm dicken, jeweils mit Haft- bzw. Anti-Tack-Schicht versehenen Polyesterfolien auf 3,0 mm Schichtdicke gepreßt. Nach 20 s Rückseitenbelichtung wird 8 min bildmäßig belichtet, 10 min mit dem im Beispiel 1 beschriebenen Entwickler bei 60 °C behandelt und anschließend 24 h bei Raumtemperatur getrocknet. Die belichtete Druckplatte besitzt eine Shore-A-Härte von 53 und ergibt in Wasser, in Ethanol bzw. in einem Gemisch aus 85 Teilen Ethanol und 15 Teilen Ethylacetat einen Quellungswert von 0,39 %, 4,72 % bzw. 14,2 %.

## Patentansprüche

1. Lichthärtbares elastomeres Gemisch, das
a) ein elastomeres Bindemittel bzw. Bindemittelgemisch,
b) eine radikalisch polymerisierbare, mit dem Bindemittel verträgliche niedermolekulare Verbindung mit mindestens einer endständigen, ethylenisch ungesättigten Gruppe und einem Siedepunkt bei Normaldruck oberhalb 100 °C und
c) eine Verbindung oder eine Verbindungskombination, die unter Einwirkung von aktinischem Licht die Polymerisation der Verbindung (b) einzuleiten vermag,
enthält, dadurch gekennzeichnet, daß als elastomeres Bindemittel ein in Wasser oder einer wäßrigen Lösung lösliches oder dispergierbares Blockcopolymerisat der allgemeinen Struktur A-B, B-A-B, C-A-B, C-A-C-B, B-C-A-C-B, AₙXBₙ, (A-B)ₙX, CₙX(A-B)ₙ, (C-A)ₙXBₙ, (C-A-B)ₙX, CₙX(A-C-B)ₙ, (C-A)ₙX(C-B)ₙ, (C-A-C)ₙXBₙ, (C-A-C-B)ₙX, BₙXAₙXBₙ, X(B-A-B)ₙX, (B-C)ₙXAₙX(C-B)ₙ, BₙX(C-A-C)ₙXBₙ oder X(B-C-A-C-B)ₙX eingesetzt wird, wobei
A hydrophobe weiche Blöcke (T_{g} < -30 °C),
B hydrophile harte Blöcke, die saure Gruppen enthalten, (T_{g} > +30 °C),
C hydrophobe harte Blöcke (T_{g} > +50 °C),
X eine Einheit, gebildet aus einer Verbindung mit zwei oder mehreren Vinyl- oder Isopropenylgruppen oder einen aus solchen Verbindungen entstandenen Homopolymerisat-Block, der in der Regel verzweigt bzw. vernetzt ist, bezeichnet und
n das zahlenmäßige Verhältnis von A/B/C-Homopolymer-Blöcken zu der Einheit X bzw. zu dem Homopolymerisatblock X angibt.

2. Lichthärtbares elastomeres Gemisch nach Anspruch 1, dadurch gekennzeichnet, daß das als Bindemittel dienende elastomere Blockcopolymerisat zu 20 bis 99 Gew.-% aus den Polymerblöcken A, zu 1 bis 30 Gew.-% aus den Polymerblöcken B und zu 0 bis 79 Gew.-% aus den Polymerblöcken C besteht.

3. Lichthärtbares elastomeres Gemisch nach Anspruch 1, dadurch gekennzeichnet, daß in dem als Bindemittel dienenden elastomeren Blockcopolymerisat die weichen Polymerblöcke A aus konjugierten Dienen, die harten Polymerblöcke B aus ethylenisch α,β-ungesättigten Carbonsäuren und die harten Polymerblöcke C aus Vinylaromaten gebildet sind.

4. Lichthärtbares elastomeres Gemisch nach Anspruch 3, dadurch gekennzeichnet, daß das konjugierte Dien 1,3-Butadien, Isopren oder 2,3-Dimethyl-1,3-butadien ist.

5. Lichthärtbares elastomeres Gemisch nach Anspruch 3, dadurch gekennzeichnet, daß die ethylenisch α,β-ungesättigte Carbonsäure Acrylsäure oder Methacrylsäure ist.

6. Lichthärtbares elastomeres Gemisch nach Anspruch 3, dadurch gekennzeichnet, daß der Vinylaromat Styrol oder Vinylnaphthalin ist.

7. Lichthärtbares elastomeres Gemisch nach Anspruch 1, dadurch gekennzeichnet, daß das als Bindemittel dienende Blockcopolymerisat ein Molekulargewicht zwischen 15 000 und 200 000 g/mol besitzt.

8. Lichthärtbares elastomeres Gemisch nach Anspruch 1, dadurch gekennzeichnet, daß die radikalisch polymerisierbare Verbindung ein Ester oder Amid der Acryl-, Methacryl-, Fumar- oder Maleinsäure mit einem ein- oder mehrwertigen Alkohol bzw. Amin ist.

9. Lichthärtbares elastomeres Gemisch nach Anspruch 1, dadurch gekennzeichnet, daß es 20 bis 95 Gew.-% elastomeres Blockcopolymerisat, 5 bis 70 Gew.-% polymerisierbare Verbindungen und 0,01 bis 10 Gew.-% Photopolymerisationsinitiator enthält.

10. Lichthärtbares Aufzeichnungsmaterial mit einem Schichtträger und einer lichthärtbaren Schicht, dadurch gekennzeichnet, daß die lichthärtbare Schicht aus einem Gemisch gemäß einem der Ansprüche 1 bis 9 besteht.

## Claims

1. Light-curable elastomeric mixture containing
a) an elastomeric binder or binder mixture,
b) a free-radically polymerisable low molecular weight compound compatible with the binder and having at least one terminal, ethylenically unsaturated group and a boiling point at standard pressure of above 100°C and
c) a compound or combination of compounds which is capable of initiating polymerisation of compound (b) under the action of actinic light,
characterised in that the elastomeric binder used is a block copolymer soluble or dispersible in water or an aqueous solution anc of the general structure A-B, B-A-B, C-A-B, C-A-C-B, B-C-A-C-B, AₙXBₙ, (A-B)ₙX, CₙX(A-B)ₙ, (C-A)ₙXBₙ, (C-A-B)ₙX, CₙX(A-C-B)ₙ, (C-A)ₙX(C-B)ₙ, (C-A-C)ₙXBₙ, (C-A-C-B)ₙX, BₙXAₙXBₙ, X(B-A-B)ₙX, (B-C)ₙXAₙX(C-B)ₙ, BₙX(C-A-C)ₙXBₙ or X(B-C-A-C-B)ₙX, wherein
A denotes hydrophobic soft blocks (T_{g} < -30°C),
B denotes hydrophilic hard blocks, which contain acidic groups, (T_{g} > +30°C),
C denotes hydrophobic hard blocks (T_{g} > +50°C),
X denotes a unit formed from a compound having two or more vinyl or isopropenyl groups or a homopolymer blcck arising from such compounds, which block is generally branched or crosslinked, and
n indicates the numerical ratio of A/B/C homopolymer blccks to the unit X or to the homopolymer block X.

2. Light-curable elastcmeric mixture according to claim 1, characterised in that the elastomeric block copolymer acting as binder consists of 20 to 99 wt.% of the polymer blocks A, of 1 to 30 wt.% of the polymer blocks B and of 0 to 79 wt.% of the polymer blocks C.

3. Light-curable elastcmeric mixture according to claim 1, characterised in that, in the elastomeric block copolymer acting as binder, the soft polymer blocks A consist of conjugated dienes, the hard polymer blocks B consist of ethylerically α,β-unsaturated carboxylic acids and the hard polymer blocks C are formed from vinyl aromatics.

4. Light-curable elastomeric mixture according to claim 3, characterised in that the conjugated diene is 1,3-butadiene, isoprene or 2,3-dimethyl-1,3-butadiene.

5. Light-curable elastcmeric mixture according to claim 3, characterised in that the ethylenically α,β-unsaturated carboxylic acid is acrylic acid or methacrylic acid.

6. Light-curable elastomeric mixture according to claim 3, characterised in that the vinyl aromatic is styrene or vinylnaphthalene.

7. Light-curable elastcmeric mixture according to claim 1, characterised in that the block copolymer acting as binder has a molecular weight of between 15,000 and 200,000 g/mol.

8. Light-curable elastcmeric mixture according to claim 1, characterised in that the free-radically polymerisable compound is an ester or amide of acrylic, methacrylic, fumaric or maleic acid with a mono- or polyfunctional alcohol or amine respectively.

9. Light-curable elastcmeric mixture according to claim 1, characterised in that it contains 20 to 95 wt.% of elastomeric block copolymer, 5 to 70 wt.% of polymerisable compounds and 0.01 to 10 wt.% of photopolymerisation initiator.

10. Light-curable recording material having a support and a light-curable layer, characterised in that the light-curable layer consists of a mixture according to one of claims 1 to 9.

## Revendications

1. Mélange élastomère photodurcissable qui contient
a) un liant, respectivement un mélange de liants élastomères,
b) un composé à bas poids moléculaire, polymérisable par voie radicalaire, compatible avec le liant, contenant au moins un groupe terminal à insaturation éthylénique et possédant un point d'ébullition sous pression normale supérieur à 100°C, et
c) un composé ou une combinaison de composés qui, sous l'influence de la lumière actinique, permet de déclencher la polymérisation du composé (b),
caractérisé en ce que, à titre de liant élastomère, on met en oeuvre un copolymère séquencé soluble ou apte à être dispersé dans l'eau ou dans une solution aqueuse, possédant la structure générale A-B, B-A-B, C-A-B, C-A-C-B, B-C-A-C-B, AₙXBₙ, (A-B)ₙX, CₙX(A-B)ₙ, (C-A)ₙXBₙ, (C-A-B)ₙX, CₙX(A-C-B)ₙ, (C-A)ₙX(C-B)ₙ, (C-A-C)ₙXBₙ, (C-A-C-B)ₙX, BₙXAₙXBₙ, X(B-A-B)ₙX, (B-C)ₙXAₙX(C-B)ₙ, BₙX(C-A-C)ₙXBₙ ou X(B-C-A-C-B)ₙX, dans lequel
A représente des séquences molles hydrophobes (Tg < -30°C),
B représente des séquences dures hydrophiles qui contiennent des groupes acides (Tg > +30°C),
C représente ies séquences dures hydrophobes (Tg > +50°C),
X représente une unité formée à partir d'un composé contenant deux groupes vinyle ou isopropényl ou plus ou encore une séquence homopolymère obtenue à partir de composés de ce type, qui est en général ramifiée, respectivement réticulée, et
n indique la proportion des séquences A/B/C de l'homopolymère par rapport à l'unité X, respectivement par rapport à la séquence homopolymère X.

2. Mélange élastomère photodurcissable selon la revendication 1, caractérisé en ce que le copolymère séquencé élastomère faisant office de liant est constitué, jusqu'à concurrence de 20 à 99% en poids, par les séquences polymères A; jusqu'à concurrence de 1 à 30% en poids, par les séquences polymères B; et jusqu'à concurrence de 0 à 79% en poids, par les séquences polymères C.

3. Mélange élastomère photodurcissable selon la revendication 1, caractérisé en ce que, dans le copolymère séquencé élastomère faisant office de liant, on obtient les séquences polymères molles A à partir de diènes conjugués, les séquences polymères dures B à partir d'acides carboxyliques à insaturation éthylénique α,β et les séquences polymères dures C à partir de composés vinylaromatiques

4. Mélange élastomère photodurcissable selon la revendication 3, caractérisé en ce que le diène conjugué est le 1,3-butadiène, l'isoprène ou le 2,3-diméthyl-1,3-butadiène.

5. Mélange élastomère photodurcissable selon la revendication 3, caractérisé en ce que l'acide carboxylique à nsaturation éthylénique α, β est l'acide acrylique ou l'acide méthacrylique.

6. Mélange élastomère photodurcissable selon la revendication 3, caractérisé en ce que le composé vinylaromatique est le styrène ou le vinylnaphtalène.

7. Mélange élastomère photodurcissable selon la revendication 1, caractérisé en ce que le copolymère séquencé faisant office de liant possède un poids moléculaire entre 15.000 et 200.000 g/mole.

8. Mélange élastomère photodurcissable selon la revendication 1, caractérisé en ce que le composé polymérisable par voie radicalaire est un ester ou un amide de l'acide acrylique, de l'acide méthacrylique, de l'acide fumarique, de l'acide maléique avec n alcool mono- ou polyvalent, respectivement une amine.

9. Mélange élastomère photodurcissable selon la revendication 1, caractérisé en ce qu'il contient, à concurrence de 20 à 95% en poids, un copolymère séquencé élastomère; à concurrence de 5 à 70% en poids, des composés polymérisables; et à concurrence de 0,01 à 10% en poids, un initiateur de la photopolymérisation.

10. Matériau d'enregistrement photodurcissable comprenant un support de couche et une couche photodurcissable, caractérisé en ce que la couche photodurcissable est constituée par un mélange selon une des revendications 1 à 9.
